# FASCICULE DE BREVET EUROPEEN

(11) **EP 3 739 873 B1**
(45) Date de publication et mention de la délivrance du brevet: **23.06.2021**
(21) Numéro de dépôt: 20171919.2
(22) Date de dépôt: 28.04.2020
(51) Int. Cl.: H04N 5/58, G09G 3/34

(54) **SYSTÈME ET PROCÉDÉ DE MESURE DE LUMIÈRE AMBIANTE**
SYSTEM UND VERFAHREN ZUM MESSEN VON UMGEBUNGSLICHT
SYSTEM AND METHOD FOR MEASURING AMBIENT LIGHT

(30) Priorité: 30.04.2019 FR 1904558
(43) Date de publication de la demande: 18.11.2020
(73) Titulaire: STMicroelectronics (Grenoble 2) SAS, 38000 Grenoble (FR)
(72) Inventeur: MAUCOTEL, David, 38500 Saint Cassien (FR)
(74) Mandataire: Cabinet Beaumont

(56) Documents cités:
- US-A1- 2009 152 445
- US-A1- 2018 263 091

## Description

### Domaine technique

La présente description concerne de façon générale les systèmes électroniques, et plus particulièrement les systèmes électroniques dans lesquels l'intensité lumineuse émise par un écran du système et perçue par un utilisateur est ajustée en fonction de de la lumière ambiante environnante.

### Technique antérieure

On connaît des systèmes électroniques tels que des téléphones mobiles ou des tablettes comprenant des écrans affichant des informations et/ou des images à destination d'un utilisateur, par exemple un utilisateur du système.

Dans de tels systèmes, la puissance lumineuse émise par l'écran peut être au moins en partie adaptée en fonction du niveau de lumière ambiante, ce niveau de lumière ambiante étant mesuré au moyen d'un capteur de lumière ambiante (ALS - Ambiant Light Sensor). L'intérêt de ce capteur est de pouvoir ensuite ajuster la puissance lumineuse émise par l'écran en fonction du niveau de lumière ambiante pour une meilleure perception de l'écran par l'oeil humain, et également pour économiser l'énergie stockée dans une batterie alimentant l'écran.

Pour mesurer l'intensité de la lumière environnante, le capteur est aujourd'hui disposé sous une glace protectrice, sous une ouverture dédiée de l'écran ou le long d'un bord de l'écran. Il serait souhaitable de disposer le capteur sous l'écran, sans ouverture dédiée dans l'écran, en utilisant la faible transmission de la lumière ambiante à travers l'écran. Toutefois, il est alors impossible pour le capteur de distinguer précisément la lumière émise par l'écran vers le bas en direction du capteur, de la lumière environnante traversant l'écran depuis l'extérieur jusqu'au capteur.

Le document US 2018/263091 A1 (2018-09-13)divulgue un dispositif d'affichage comprenant un capteur de lumière ambiante.

### Résumé de l'invention

Il existe un besoin de pallier tout ou partie des inconvénients des systèmes électroniques connus dans lesquels la puissance lumineuse émise par un écran est au moins en partie déterminée par le niveau de lumière ambiante mesuré par un capteur du système.

Ainsi, un mode de réalisation pallie tout ou partie des inconvénients des systèmes électroniques connus dans lesquels la puissance lumineuse émise par un écran est au moins en partie déterminée par le niveau de lumière ambiante mesuré par un capteur du système.

En particulier, un mode de réalisation permet d'éviter que le niveau de lumière ambiante mesuré par le capteur ne soit faussé par la lumière émise par l'écran.

L'invention a pour objet un système électronique tel que revendiqué à la revendication 1, un dispositif électronique tel que revendiqué à la revendication 11 ainsi qu'un procédé tel que revendiqué à la revendication 12. Des modes de réalisation particuliers sont définis dans les revendications dépendantes 2 à 10.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un mode de réalisation d'un dispositif électronique ;
la figure 2 représente un autre mode de réalisation d'un dispositif électronique ;
la figure 3 représente, de manière très schématique et sous forme de blocs, un système électronique du dispositif de la figure 1 ou 2 ;
la figure 4 représente, de manière très schématique et sous forme de blocs, un mode de réalisation d'une partie du système électronique de la figure 3 ;
la figure 5 représente, de manière très schématique et sous forme de blocs, un autre mode de réalisation d'une partie du système électronique de la figure 3 ;
la figure 6 représente, de manière très schématique et sous forme de blocs, un autre mode de réalisation d'une partie du système électronique de la figure 3 ;
la figure 7 représente, de manière très schématique et sous forme de blocs, une variante de réalisation de la partie du système électronique représentée en figure 6 ; et
la figure 8 représente des chronogrammes illustrant un mode de fonctionnement du système électronique des figures 3 à 7.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Dans la suite de la description, on considère des systèmes électroniques dans lesquels l'écran fonctionne en alternant des phases où l'écran émet de la lumière et des phases où l'écran est éteint, c'est-à-dire où l'écran n'émet aucune lumière. Dans de tels systèmes, la puissance lumineuse moyenne émise par l'écran et perçue par un utilisateur est adaptée en modifiant la durée des phases d'émission de lumière et/ou la durée des phases où aucune lumière n'est émise. L'écran est alors commandé par un signal binaire dont un premier état binaire, correspondant par exemple à un niveau de potentiel haut, commande une phase d'émission de lumière par l'écran, et dont un deuxième état binaire, correspondant par exemple à un niveau de potentiel bas tel que la masse, commande une phase où aucune lumière n'est émise par l'écran. Avec des fréquences adéquates de commutation entre les phases où l'écran émet de la lumière et les phases où l'écran est éteint, l'utilisateur de l'écran ne perçoit pas les transitions entre ces phases, grâce à la persistance rétinienne de l'oeil humain.

A titre d'exemple, le signal binaire de commande est généralement modulé en largeur d'impulsion (PWM - Pulse Width Modulation). Le type d'écran, par exemple LCD ("Liquid Cristal Display" - écran à cristaux liquides) ou OLED ("Organic Light Emitting Diode"), auquel s'appliquent de tels modes de commande et la façon dont sont mis en oeuvre ces modes de commande n'ont pas été détaillés. Les modes de réalisation décrits sont compatibles avec ces modes de commande connus et les écrans connus auxquels s'appliquent ces modes de commande.

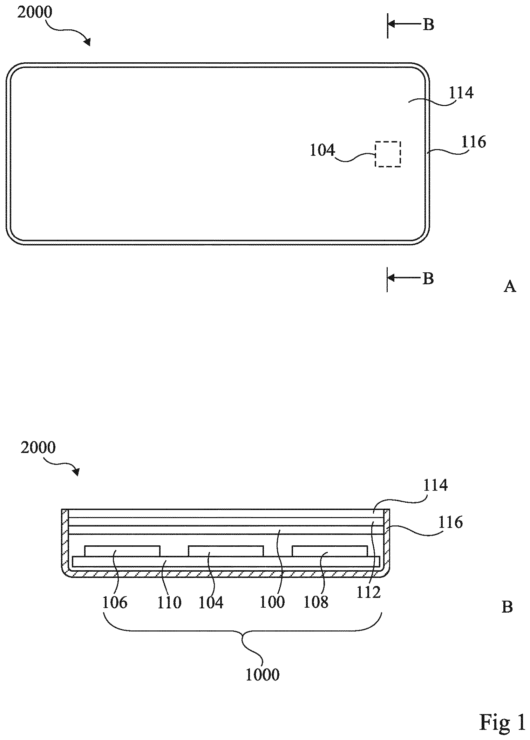

La figure 1 représente deux vues A et B d'un mode de réalisation d'un dispositif électronique 2000, dans cet exemple un téléphone mobile 2000, la vue A étant une vue de face du téléphone 2000 et la vue B étant une vue en coupe selon le plan BB de la vue A.

Le dispositif 2000 comprend un système électronique 1000. Le système électronique 1000 comporte un écran 100 destiné à afficher des images et/ou des informations à destination d'un utilisateur. L'écran, ou panneau, d'affichage 100 comprend une matrice de pixels (non représentés) émettant de la lumière.

Le système 1000 comprend en outre divers circuits électroniques dont un capteur de lumière ambiante 104. Dans l'exemple de la figure 1, en vue B, deux autres circuits électroniques, à savoir une unité de traitement 106 et un circuit 108 de pilotage, ou de commande, de l'écran 100, sont représentés.

Les divers circuits électroniques du système 1000 sont par exemple montés sur une carte 110 de circuit imprimé (PCB - Printed Circuit Board), de préférence une carte de circuit imprimé flexible, pour être électriquement reliés entre eux via la carte 110. Bien qu'une seule carte 110 soit représentée en vue B de la figure 1, le système 1000 peut comprendre plusieurs cartes 110 éventuellement reliées électriquement entre elles via des nappes de connexion.

A titre d'exemple, l'écran d'affichage 100 peut être de type à diodes électroluminescentes organiques (OLED). L'écran 100 est alors par exemple commandé par un signal binaire de commande, par exemple généré par le circuit de pilotage 108. Ce signal de commande est par exemple fourni sélectivement à chaque diode de l'écran, de manière à alterner des phases où au moins certaines diodes de l'écran 100 émettent de la lumière et des phases où aucune diode de l'écran 100 n'émet de lumière. La sélection des diodes de l'écran 100 recevant ou non le signal de commande est par exemple mise en oeuvre par le circuit de pilotage 108. Dans certains cas, le circuit de pilotage 108 peut en outre adapter, pour chaque diode, le niveau de tension du signal binaire correspondant à une phase d'émission de lumière de manière à adapter la puissance lumineuse émise par la diode. Chaque pixel de l'écran peut être constitué d'une ou plusieurs diodes, éventuellement revêtues de filtre de couleur RGB (Red, Green, Blue - rouge, vert, bleu).

A titre d'exemple, l'écran d'affichage 100 peut aussi être de type à cristaux liquides (LCD). L'écran 100 comprend alors par exemple une matrice de pixels comprenant chacun des filtres polarisants à cristaux liquides, et une dalle éclairante disposée sous la matrice de pixels. La dalle est par exemple commandée par un signal binaire de commande, par exemple généré par le circuit de pilotage 108, de sorte que la dalle fonctionne en alternant des phases d'émission de lumière et des phases où la dalle n'émet aucune lumière. Dans certains cas, le circuit de pilotage peut en outre adapter le niveau de tension du signal binaire correspondant à une phase d'émission de lumière de manière à adapter la puissance lumineuse émise par la dalle. Les filtres polarisants de chaque pixel sont commandés, par exemple par le circuit 108 de pilotage de l'écran 100, pour laisser ou non passer la lumière émise par la dalle à travers les filtres polarisants, vers un utilisateur. Chaque pixel de l'écran peut être revêtu d'un ou plusieurs filtres de couleur RGB.

Dans l'exemple représenté, le système 1000 comprend en outre, au-dessus de l'écran d'affichage 100, un écran tactile 112. L'écran tactile, ou dalle tactile, 112 recouvre entièrement l'écran d'affichage 100, les écrans 100 et 112 ayant sensiblement les mêmes surfaces, de préférence les mêmes surfaces.

De manière classique, le dispositif 2000 comprend une vitre de protection 114 recouvrant l'écran 100, et, plus particulièrement dans cet exemple, l'ensemble constitué des deux écrans 100 et 112. La vitre 114 recouvre entièrement l'écran 100, la surface de la vitre 114 étant sensiblement égale à celle de l'écran 100, de préférence égale à celle de l'écran 100.

Le dispositif 2000 comprend un boitier, ou coque, 116, dans lequel est disposé le système 1000, c'est-à-dire dans lequel sont disposés les circuits électroniques 104, 106 et 108 et la ou les cartes 110. L'ensemble de l'écran 100, de l'éventuel écran tactile 112 et de la vitre 114 ferme le boîtier 116 du côté d'une face du système, la face supérieure dans la vue B de la figure 1, et la face visible dans la vue A de la figure 1.

Dans ce mode de réalisation, le téléphone 2000 est dit "sans bord" ("borderless" en anglais), c'est-à-dire que l'écran 100, et plus particulièrement l'ensemble de l'écran 100, de l'éventuel écran tactile 112 et de la vitre 114 occupe sensiblement toute la face, de préférence toute la face, du dispositif destinée à être visualisée par l'utilisateur du système, c'est-à-dire la face supérieure du dispositif 2000 en vue B de la figure 1. Le capteur de lumière ambiante 104 est alors disposé sous l'écran 100, c'est-à-dire du côté de l'écran 100 opposé à la face de l'écran 100 visible par l'utilisateur. L'écran d'affichage 100, l'écran tactile 112 et la vitre 114 sont alors au moins partiellement transparents à la lumière ambiante, la lumière ambiante correspondant ici à de la lumière visible et éventuellement à de la lumière infra-rouge et/ou ultra-violette. Ainsi, de la lumière ambiante peut passer à travers l'ensemble de la vitre 114, de l'éventuel écran tactile 112 et de l'écran d'affichage 100, et atteindre le capteur 104.

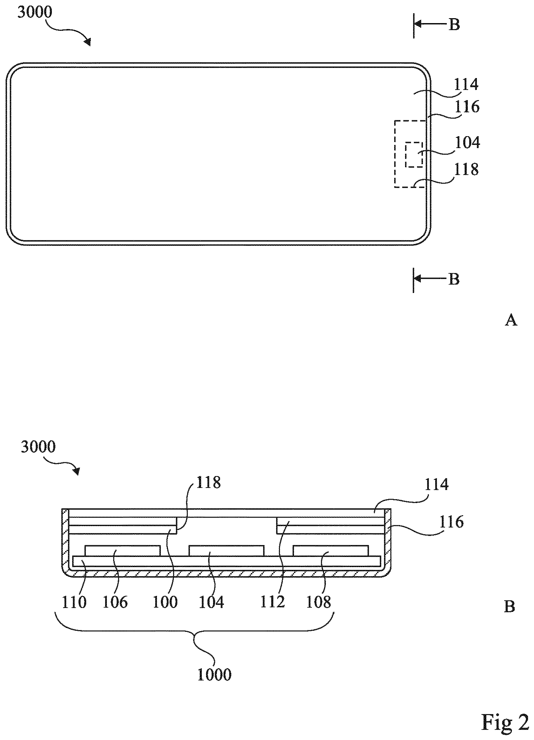

La figure 2 représente deux vues A et B d'un autre mode de réalisation d'un dispositif électronique 3000, dans cet exemple un téléphone mobile 3000, la vue A étant une vue de face du téléphone et la vue B étant une vue en coupe selon le plan BB de la vue A.

Le dispositif 3000 de la figure 2 diffère du dispositif 2000 de la figure 1 en ce que l'écran d'affichage 100 et l'éventuel écran tactile 112 sont interrompus au-dessus du capteur 104 pour permettre à de la lumière ambiante d'atteindre le capteur 104. Plus particulièrement, une encoche 118 est prévue dans l'écran 100 et l'éventuel écran 112, au-dessus du capteur 104. La vitre 114 recouvre l'encoche 118 de manière à protéger les circuits électroniques disposés dans le boitier 116, et en particulier le capteur 104.

On notera que les dispositifs 2000 et 3000 sont représentés de manière très schématique, et que tous les détails de ces dispositifs ne sont pas représentés. Les modes de réalisation qui vont être décrits par la suite ne se limitent pas aux exemples de dispositifs des figures 1 et 2, mais s'appliquent à tous les dispositifs électroniques comprenant un système électronique 1000, par exemple des tablettes, des montres connectées, des écrans d'ordinateur, des téléphones mobiles, des appareils multimédia dotés d'un écran, par exemple flexibles ou pliables, etc.. Plus particulièrement, les modes de réalisation décrits s'appliquent à des systèmes électroniques 1000 comportant un écran d'affichage 100 et un capteur de lumière ambiante 104 disposé sous l'écran 100 comme cela est représenté en figure 1, ou sous une encoche, ou ouverture, 118 de l'écran 100 comme cela est représenté en figure 2, dans lesquels l'écran 100 fonctionne en alternant des phases d'émission de lumière et des phases où aucune lumière n'est émise.

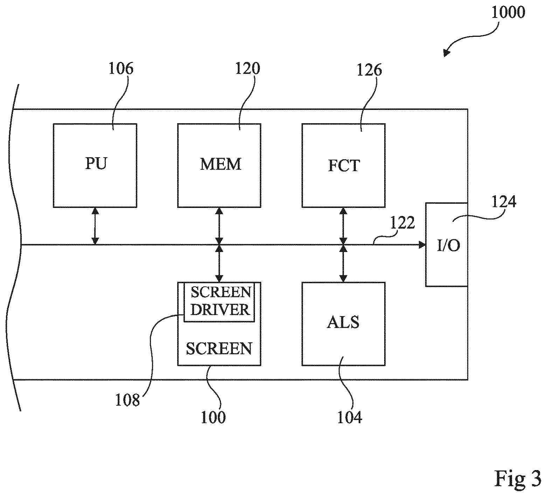

La figure 3 représente, de manière très schématique et sous forme de blocs, le système électronique 1000 de la figure 1 ou 2.

Le système 1000 comporte :
- l'unité de traitement 106 (PU), par exemple une machine d'états, un microprocesseur, un microcontrôleur, un circuit logique programmable, etc. ;
- une ou plusieurs zones de stockage 120 (MEM), chaque zone de stockage, ou mémoire, pouvant être volatile, par exemple de type mémoire RAM ou registres, pour stocker temporairement des informations (instructions, adresses, données) pendant les traitements, ou non volatile, par exemple de type flash, pour stocker des informations de façon durable et en particulier quand le système 1000 n'est pas alimenté;
- un ou plusieurs bus de données, d'adresses et/ou de commandes entre les circuits électroniques internes au système 1000, représentés ici sous la forme d'un unique bus 122 ;

- une interface d'entrée-sortie 124 (I/O) de communication, par exemple de type bus série, avec l'extérieur du système 1000 ;
- l'écran (SCREEN) 100 ;
- le circuit 108 de pilotage (SCREEN DRIVER) de l'écran 100, représenté ici comme faisant partie de l'écran 100 ; et
- le capteur de lumière ambiante (ALS) 104.

Par ailleurs, le système 1000 peut intégrer d'autres fonctions, symbolisées par un bloc 126 (FCT), par exemple, un crypto-processeur, d'autres interfaces, d'autres mémoires, une caméra, un capteur d'image, etc.

La ou les alimentations électriques des divers éléments du système 1000, en particulier l'alimentation électrique du circuit 108, ne sont pas représentées en figure 3.

Dans le système 1000, l'unité de traitement 106 est configurée pour fournir un signal de consigne au circuit 108. Ce signal de consigne est représentatif d'une valeur de consigne de la puissance lumineuse moyenne que l'écran 100 doit émettre. A titre d'exemple, cette valeur de consigne est déterminée à partir d'un signal de mesure fourni par le capteur 104, le signal de mesure étant représentatif de la quantité de lumière, ou plus exactement de la quantité de photons, reçue par le capteur 104 pendant une phase de mesure du niveau de lumière ambiante. La dépendance de la valeur de consigne au niveau de lumière ambiante mesuré permet un ajustement automatique de la puissance lumineuse émise par l'écran en fonction du niveau de lumière ambiante. Cette valeur de consigne peut également dépendre d'une consigne de luminosité de l'écran 100 fournie au système 1000 par l'utilisateur, de manière manuelle.

En fonction de ce signal de consigne, le circuit 108 adapte le signal de commande binaire qu'il fournit à l'écran 100, et plus particulièrement adapte la durée pendant laquelle le signal est dans le premier état binaire, et/ou la durée pendant laquelle le signal est dans le deuxième état binaire. Cela revient à adapter la durée des phases de fonctionnement où l'écran 100 émet de la lumière et/ou la durée des phases de fonctionnement où l'écran n'émet aucune lumière, de sorte que la luminosité moyenne émise par l'écran sur un grand nombre de phase de fonctionnement, par exemple plus de 100, corresponde à la luminosité moyenne de consigne. On notera que c'est la luminosité moyenne émise par l'écran qui est perçue par l'utilisateur, du fait que les transitions entre les phases d'émission de lumière par l'écran et de non émission de lumière par l'écran sont imperceptibles pour l'oeil humain en raison de la persistance rétinienne. A titre d'exemple, lorsque le signal de commande de l'écran est modulé en largeur d'impulsion, le circuit 108 augmente ou diminue le rapport cyclique du signal, et, de manière optionnelle, le circuit 108 peut également modifier la fréquence du signal.

Un inconvénient des systèmes 1000 dans lesquels le capteur 104 est disposé sous l'écran 100, ou à proximité de l'écran 100, par exemple le long d'un bord de l'écran 100 ou sous une encoche ou ouverture 118 de l'écran 100, est que de la lumière émise par l'écran peut atteindre le capteur 104, et donc fausser la mesure du niveau de lumière ambiante.

Dans le cas plus particulier où le capteur 104 est disposé sous l'écran 100, la vitre 114 et l'éventuel écran tactile 112, le taux de transmission de lumière ambiante jusqu'au capteur 104 peut être très faible, par exemple inférieur à 5 %, voire 1 %. Dans ce cas, la lumière émise par l'écran 100 qui atteint le capteur 104 peut avoir une puissance lumineuse comparable à la lumière ambiante transmise jusqu'au capteur 204, ce qui pose problème.

Pour pallier ces inconvénients, l'inventeur propose ici de tirer parti du mode de commande de l'écran 100, et plus particulièrement de l'alternance des phases de fonctionnement où l'écran 100 émet de la lumière avec celles où l'écran 100 n'émet aucune lumière. Plus particulièrement, l'inventeur propose ici de prévoir, dans le système 1000, un dispositif ou des moyens ou circuits de synchronisation configurés pour que chaque phase de mesure du niveau de lumière ambiante par le capteur 104 soit mise en oeuvre pendant une phase de fonctionnement où l'écran 100 n'émet pas de lumière. Autrement dit, l'inventeur propose ici de prévoir un dispositif de synchronisation configuré pour synchroniser chaque phase de mesure du capteur 104 avec une phase de fonctionnement où l'écran 100 n'émet aucune lumière, et plus particulièrement un dispositif de synchronisation configuré pour synchroniser le début de chaque phase de mesure du niveau de lumière ambiante avec le début d'une phase de fonctionnement où l'écran n'émet aucune lumière. En effet, une phase de mesure par le capteur 104 a généralement une durée inférieure à celle des phases où l'écran 100 n'émet aucune lumière lorsque l'écran est commandé en modulation de largeur d'impulsion. Ainsi, la mesure effectuée par le capteur 104 n'est pas faussée par de la lumière émise par l'écran qui pourrait atteindre le capteur 104.

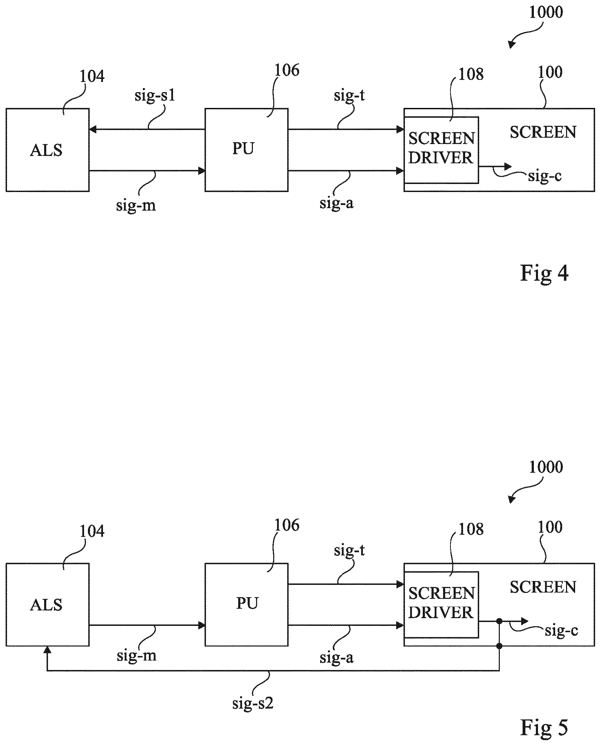

Divers modes de réalisation vont maintenant être décrits plus en détails en relation avec les figures 4, 5, 6 et 7.

La figure 4 représente, sous forme de blocs et de manière plus détaillée, un mode de réalisation d'une partie du système électronique 1000 de la figure 3. La figure 4 représente plus particulièrement le capteur 104, l'unité centrale 106 et le circuit 108 de pilotage de l'écran 100, le circuit 108 faisant partie de l'écran 100 dans cet exemple.

Dans ce mode de réalisation, le dispositif de synchronisation comprend l'unité de traitement 106. La synchronisation des phases de mesure du capteur 104 avec les phases de fonctionnement où l'écran 100 n'émet pas de lumière est alors au moins en partie mise en oeuvre par l'unité de traitement 106.

Comme cela a été décrit précédemment, l'unité de traitement 106 est configurée pour fournir un signal de consigne, référencé sig-t, au circuit 108.

Selon un mode de réalisation, l'unité 106 est en outre configurée pour fournir un signal d'activation sig-a au circuit 108. Le signal sig-a indique au circuit 108 s'il doit ou non fournir le signal de commande binaire, référencé sig-c, à l'écran 100. Autrement dit, le signal sig-a indique si l'écran 100 doit être en fonctionnement et commandé par le signal sig-c (circuit 108 actif), ou si l'écran 100 doit être éteint (circuit 108 inactif) . Lorsque le circuit 108 est actif, le signal binaire de commande sig-c commande l'alternance des phases de fonctionnement où l'écran 100 émet de la lumière avec celles où l'écran 100 n'émet aucune lumière.

Le capteur 104 est configuré pour fournir, après chaque mesure du niveau de lumière ambiante, un signal de mesure sig-m représentatif de la quantité de lumière reçue pendant cette phase de mesure. Le signal sig-m est par exemple déterminé par le capteur 104 pendant une phase de traitement suivant la phase de mesure, cette phase de traitement pouvant être mise en oeuvre quel que soit l'état du signal binaire de commande, c'est-à-dire que l'écran 100 soit dans une phase d'émission ou non de lumière.

Bien que cela ne soit pas représenté ici, selon un mode de réalisation, le capteur 104 est configuré pour mettre en oeuvre plusieurs phases de mesure successives avant de fournir le signal sig-m, ce dernier étant alors représentatif de la quantité de lumière totale reçue pendant ces phases de mesure successives. A titre d'exemple, l'unité 106 est alors configurée pour fournir au capteur 104 un signal indiquant si plusieurs phases de mesure doivent être réalisées successivement avant de fournir le signal sig-m correspondant, ou si le signal sig-m doit être fourni après chaque phase de mesure.

Dans ce mode de réalisation, l'unité centrale 106 est configurée pour fournir au capteur 104 un signal sig-s1 de synchronisation du début de chaque phase de mesure. Plus particulièrement, le signal sig-s1 indique, par exemple par un changement d'état binaire lorsque le signal sig-s1 est un signal binaire, que le capteur 104 doit débuter une phase de mesure. L'unité 106 peut ainsi synchroniser, via le signal sig-s1, le début de chaque phase de mesure avec une phase de fonctionnement où le signal de commande sig-c est dans le deuxième état binaire, c'est-à-dire une phase de fonctionnement où l'écran 100 n'émet aucune lumière.

A titre d'exemple, l'unité 106 détermine le signal sig-s1 à partir du signal de consigne sig-t qu'elle fournit au circuit 108. En effet, l'unité 106 peut déduire du signal sig-t les caractéristiques (fréquence, rapport cyclique, etc...) du signal de commande sig-c, par exemple à partir d'une table de correspondance entre chaque valeur pouvant être prise par le signal sig-t et les caractéristiques correspondantes du signal sig-c.

Le mode de réalisation de la figure 4 est plus particulièrement adapté au cas où le signal sig-c est modulé en largeur d'impulsion. Dans ce cas, l'unité 106 détermine par exemple l'instant auquel le circuit 108 passe d'un état désactivé à un état activé à partir du signal sig-a, et peut en déduire l'instant de début de chaque alternance d'une phase de fonctionnement où l'écran émet de la lumière et d'une phase de fonctionnement où l'écran n'émet aucune lumière. Pour chaque alternance, l'instant de début de la phase où l'écran n'émet pas de lumière peut correspondre à l'instant de début de l'alternance, ou être déduit de l'instant de début de l'alternance et de la connaissance du rapport cyclique du signal sig-c, le rapport cyclique du signal sig-c étant par exemple déterminé à partir du signal de consigne sig-t.

La figure 5 représente, sous forme de blocs et de manière plus détaillée, un autre mode de réalisation d'une partie du système électronique 1000 de la figure 3. Plus particulièrement, la figure 5 représente le capteur 104, l'unité centrale 106 et le circuit 108 de pilotage de l'écran 100, le circuit 108 faisant partie de l'écran 100 dans cet exemple. Seules les différences entre la partie du système 1000 représentée en figure 4 et celle représentée en figure 5 sont ici détaillées.

Dans ce mode de réalisation, le dispositif de synchronisation des phases de mesure du capteur 104 avec les phases où l'écran 100 n'émet pas de lumière comprend le capteur 104. Cette synchronisation est alors au moins en partie mise en oeuvre par le capteur 104, à partir d'un signal de synchronisation sig-s2 représentatif du signal de commande sig-c fourni à l'écran 100.

Dans le mode de réalisation de la figure 5, l'unité 106 ne fournit pas de signal sig-s1.

En outre, dans le mode de réalisation de la figure 5, le capteur 104 est configuré pour recevoir le signal de synchronisation sig-s2 représentatif du signal de commande sig-c. Dans cet exemple, le signal sig-s2 est identique au signal sig-c. Dans d'autres exemples non représentés, le signal sig-s2 peut correspondre au signal sig-c dont les niveaux de potentiel correspondant aux premier et deuxième états binaires ont été adaptés, par exemple par le circuit 108 ou par un circuit dédié.

Le signal sig-s2 fourni au capteur 104 lui permet de connaître, ou déterminer, l'instant de début de chaque phase où l'écran 100 n'émet pas de lumière. Le capteur 104 est alors configuré pour synchroniser chacune de ses phases de mesure avec une phase de fonctionnement où l'écran 100 n'émet pas de lumière. Dans cet exemple où les signaux sig-c et sig-s2 sont identiques, la commutation du signal sig-s2 du premier état binaire au deuxième état binaire indique le début d'une phase de fonctionnement où l'écran n'émet aucune lumière et le capteur 104 peut alors synchroniser le début d'une phase de mesure avec le début de cette phase de fonctionnement.

Par rapport au mode de réalisation de la figure 4, le mode de réalisation de la figure 5 permet de limiter le décalage temporel entre le début d'une phase où l'écran 100 n'émet pas de lumière et le début d'une phase de mesure. Cela résulte du fait que, dans le mode de réalisation de la figure 5, le signal de synchronisation sig-s2 reçu par le capteur 104 est directement obtenu du signal de commande sig-c, alors que, dans le mode de réalisation de la figure 4, le circuit 108 et/ou l'unité de traitement 106 peuvent introduire un décalage temporel entre le signal de commande sig-c et le signal de synchronisation sig-s1 reçu par le capteur 104. A titre d'exemple, ce décalage temporel peut être dû à plusieurs circuits communiquant chacun à leur tour, par exemple via les bus du système, et partageant les mêmes signaux de commande.

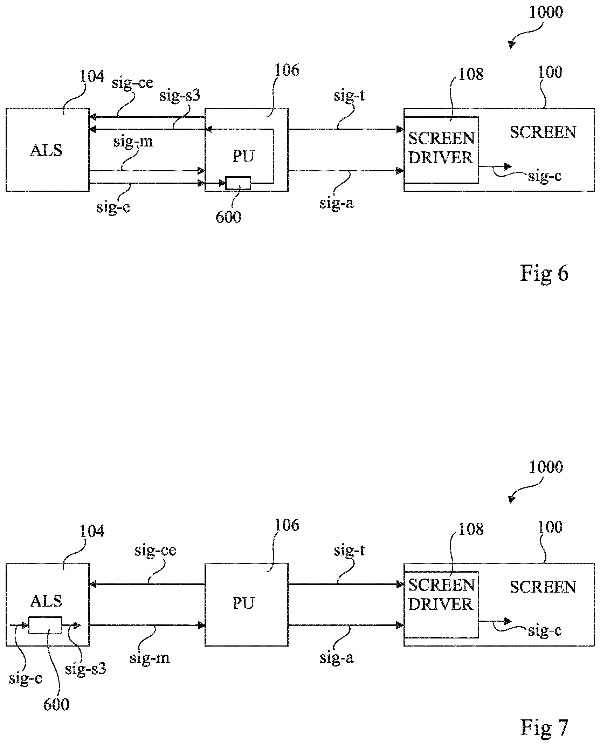

La figure 6 représente, sous forme de blocs et de manière plus détaillée, un autre mode de réalisation d'une partie du système électronique 1000 de la figure 3. Plus particulièrement, la figure 6 représente le capteur 104, l'unité centrale 106 et le circuit 108 de pilotage de l'écran 100, le circuit 108 faisant partie de l'écran 100 dans cet exemple. Seules les différences entre la partie du système 1000 représentée en figure 5 et celle représentée en figure 6 sont ici détaillées.

Dans ce mode de réalisation, on prévoit d'extraire des caractéristiques du signal de commande sig-c, à partir d'un signal sig-e représentatif de l'évolution temporelle de la puissance lumineuse reçue par le capteur 104. La synchronisation entre les phases de mesure du capteur 104 et les phases de fonctionnement où l'écran n'émet aucune lumière est alors mise en oeuvre à partir de ces caractéristiques extraites. Ainsi, dans ce mode de réalisation, le dispositif de synchronisation comprend le capteur 104, qui est alors configuré pour fournir le signal sig-e, et un circuit de traitement 600 configuré pour extraire des caractéristiques du signal sig-c à partir du signal sig-e.

On tire ici parti du fait que, lors d'une phase d'émission de lumière par l'écran 100, une partie de cette lumière émise est reçue par le capteur 104 et s'ajoute à la lumière ambiante reçue par le capteur 104. Ainsi, des caractéristiques du signal de commande sig-c telles que la fréquence du signal sig-c, les plages temporelles où le signal sig-c est respectivement dans le premier état binaire et dans le deuxième état binaire, le rapport cyclique du signal sig-c, etc., peuvent être extraites du signal sig-e. A titre d'exemple, le signal sig-e est un signal analogique dont l'amplitude varie avec la puissance lumineuse reçue par le capteur.

Dans ce mode de réalisation, le circuit 600 fait partie de l'unité 106, le signal sig-e étant alors fourni à l'unité de traitement 106. En variante, le circuit 600 peut être un circuit dédié, externe à l'unité 106, correspondant par exemple à un bloc FCT (figure 3).

Selon un mode de réalisation, tant que l'unité 106 envoie un signal de commande sig-ce au capteur 104, le capteur 104 fournit le signal sig-e. Dans une variante de réalisation non représentée, l'unité 106 ne fournit aucun signal sig-ce au capteur 104, qui fournit alors le signal sig-e de manière continue.

Selon un mode de réalisation, en plus d'être configuré pour extraire des caractéristiques du signal sig-c à partir du signal sig-e, le circuit 600 est configuré pour déterminer un signal de synchronisation sig-s3 fourni au capteur 104. En variante, l'unité centrale 106 détermine le signal sig-s3 à partir des caractéristiques extraites du signal sig-e par le circuit 600.

Le signal sig-s3 indique au capteur 104 à quels instants débutent les phases de fonctionnement de l'écran 100 où ce dernier n'émet aucune lumière. Le capteur 104 est alors configuré pour synchroniser le début de chaque phase de mesure du niveau de lumière ambiante avec un instant de début d'une phase de fonctionnement où l'écran 100 n'émet aucune lumière.

Un avantage du mode de réalisation de la figure 6 par rapport aux modes de réalisation des figures 4 et 5 est que la synchronisation est basée sur le signal sig-e qui tient compte d'éventuels décalages entre les changements de niveaux du signal sig-c et les changements de phases (émission ou non de lumière) de fonctionnement de l'écran. A titre d'exemple ce décalage peut résulter d'un décalage entre la commande de l'écran et l'affichage par l'écran, par exemple dû à une latence d'affichage, au temps de montée des diodes électroluminescentes de l'écran et/ou à une congestion des bus ou voies de communication du système.

La figure 7 représente sous forme de blocs une variante de réalisation du mode de réalisation décrit en relation avec la figure 6. Seules les différences entre les systèmes 1000 des figures 6 et 7 sont détaillées.

En figure 7, le circuit de traitement 600 fait partie du capteur 104 plutôt que de l'unité 106. Ainsi, à la différence du mode de réalisation de la figure 6 où le signal sig-e est transmis à l'unité 106 qui, en retour, fourni le signal sig-s3 au capteur 104, dans la variante de réalisation de la figure 7, ces signaux sig-e et sig-s3 sont internes au capteur 104. En particulier, on prévoit ici que le capteur 104, et en particulier son circuit de traitement 600, soient configurés pour déterminer la fréquence de l'alternance entre les phases d'émission de lumière par l'écran et les phases où l'écran est éteint, le début de chaque phase d'émission de lumière par l'écran, la fin de chaque phase d'émission de lumière par l'écran et/ou le rapport cyclique entre les phases d'émission de lumière par l'écran et les phases où l'écran est éteint. Ainsi, le capteur 104 est autonome et est en mesure, sur la base des informations ci-dessus, de mettre en oeuvre des phases de capture de lumière lorsque l'écran est dans une phase de fonctionnement où il n'émet pas de lumière.

La variante de réalisation de la figure 7 bénéficie des mêmes avantages que le mode de réalisation de la figure 6. La variante de réalisation de la figure 7 est en outre plus simple que le mode de réalisation de la figure 6 car la synchronisation des phases de capture de la lumière environnante avec les phases de fonctionnement où l'écran n'émet pas de lumière est mise en oeuvre en interne du capteur 104, ce qui simplifie l'intégration du capteur 104 dans un système électronique 1000.

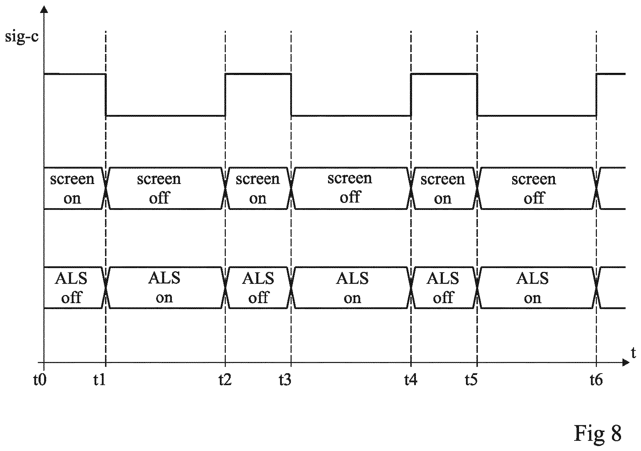

La figure 8 représente des chronogrammes illustrant un mode de fonctionnement du système 1000 décrit précédemment. Dans cet exemple, une phase de mesure du niveau de lumière ambiante est mise en oeuvre par le capteur 104 lors de chaque phase où l'écran n'émet pas de lumière.

En figure 8, on a représenté le signal sig-c de commande des phases d'émission de lumière par l'écran et des phases où l'écran n'émet pas de lumière, le circuit 108 étant ici actif. Dans cet exemple, le niveau bas du signal sig-c commande l'écran pour qu'il n'émette pas de lumière ("screen off"), et le niveau haut du signal sig-c commande l'écran pour qu'il émette de la lumière ("screen on").

En figure 8, on a également représenté les phases de mesure du niveau de lumière ambiante par le capteur 104 ("ALS on") et les phases où le capteur ne mesure pas le niveau de lumière ambiante ("ALS off") . On considère ici qu'une phase de mesure du niveau de lumière ambiante par le capteur correspond à une phase d'intégration par le capteur 104, c'est-à-dire une phase où des photons sont réceptionnés par une zone photosensible du capteur. Le traitement du nombre de photons reçu pendant une phase d'intégration ou de mesure du niveau de lumière ambiante, par exemple pour générer le signal sig-m représentatif du nombre de photon reçu pendant cette phase d'intégration, c'est-à-dire représentatif du niveau de lumière ambiante, étant réalisé, dans cet exemple, après chaque phase d'intégration, par exemple au moins en partie pendant la phase suivante d'émission de lumière par l'écran.

Plus particulièrement, dans cet exemple, des phases d'émission de lumière par l'écran débutent aux instants respectifs t0, t2, t4, et t6 et se terminent aux instants respectifs t1, t3 et t5, les instants t0, t1, t2, t3, t4, t5 et t6 étant des instants successifs. Ainsi, comme cela a été décrit précédemment, dans cet exemple, des phases de mesure du niveau de lumière ambiante par le capteur 105 sont mises en oeuvre respectivement entre les instants t1 et t2, entre les instants t3 et t4, et entre les instants t5 et t6. Plus particulièrement, à chacun des instants t1, t3 et t5 débute une phase de mesure du niveau de lumière ambiante correspondante.

Bien que, en figure 8, chaque phase de mesure du niveau de lumière ambiante se termine à la fin d'une phase correspondante où l'écran n'émet pas de lumière (instants t2, t4 et t6), en pratique, chaque phase de mesure du niveau de lumière ambiante peut se terminer avant la fin de la phase correspondante où l'écran n'émet pas de lumière.

Bien que cela ne soit pas représenté en figure 8, lorsque le capteur 104 a terminé une phase de mesure, le capteur débute une phase de traitement lors de laquelle il détermine, ou met à jour, le signal sig-m représentatif du niveau de lumière ambiante mesuré pendant la phase de mesure. Cette phase de traitement peut commencer pendant la phase correspondante où l'écran n'émet pas de lumière, et se poursuivre ou être entièrement mise en oeuvre pendant la phase suivante où l'écran émet de la lumière.

En outre, bien que cela ne soit pas représenté, selon le mode de réalisation mis en oeuvre, chaque phase de mesure du niveau de lumière ambiante par le capteur 104 peut débuter en retard par rapport au début de la phase correspondante où l'écran n'émet pas de lumière. Toutefois, chaque phase de mesure du niveau de lumière par le capteur se termine au plus tard à la fin de la phase correspondante où l'écran n'émet pas de lumière.

A titre d'exemple, les phases où l'écran n'émet pas de lumière ont une durée de l'ordre 3,6 ms, voire moins, les phases où l'écran émet de la lumière ayant une durée de l'ordre de 0,4 ms, voire moins. A titre d'exemple, une phase de mesure ou d'intégration du niveau de lumière ambiante par le capteur 104 a une durée de l'ordre 0,1 ms à 1 ms, de préférence en tenant compte des éventuels délais de traitement des divers circuits optiques et électroniques mis en jeu.

Dans les modes de réalisation et variantes décrits ci-dessus, le capteur 104 peut être configuré pour fournir un signal sig-m représentatif de la lumière reçue pendant une ou plusieurs phases de mesure pour une unique plage de longueur d'onde, par exemple la plage des longueurs d'onde dans le visible éventuellement étendue aux longueurs d'onde infrarouges et/ou ultra-violettes. Dans ce cas, le système 1000 ne peut pas déterminer le type de lumière ambiante qu'il reçoit. En variante, le capteur 104 peut être configuré pour fournir un signal sig-m comprenant, pour chacune d'une pluralité de plages de longueurs d'onde, une information représentative de la quantité de lumière reçue, dans cette plage de longueurs d'onde, par le capteur lors d'une ou plusieurs phases de mesures. Dans ce cas, le système 1000 peut être configuré pour déterminer le type de lumière ambiante, par exemple si la lumière est naturelle, issue d'une lampe à incandescence, issue d'une lampe à fluorescence, si la lumière est une lumière froide ou chaude, etc. Dans le cas où l'écran 100 est un écran couleur de type OLED, l'unité 106 peut alors être configurée pour fournir un signal sig-t comprenant, pour chaque plage de longueurs d'onde que l'écran 100 peut émettre, une indication de la puissance moyenne cible que l'écran 100 doit émettre pour cette plage de longueurs d'onde. En effet, dans le cas d'un écran couleur OLED, le circuit 108 est généralement configuré pour contrôler individuellement chaque pixel de l'écran. Il en résulte que le système 1000 peut alors adapter le type de lumière émise par son écran 100 au type de lumière ambiante.

Par ailleurs, bien que cela n'ait pas été décrit, en raison des délais de transmission et de traitement des signaux sig-t, sig-a, sig-e et sig-s1, sig-s2 ou sig-s3, l'instant de début d'une phase de fonctionnement où l'écran 100 n'émet pas de lumière qui est indiqué par le signal sig-s1, sig-s2 ou sig-s3 peut être postérieur à l'instant où cette phase débute réellement. Le système 1000 peut alors comprendre un circuit de retard configuré pour tenir compte de ces délais de transmission et de traitement. Par exemple, le circuit de retard est configuré pour retarder le signal de synchronisation sig-s1, sig-s2 ou sig-s3 de sorte que l'instant de début d'une phase de fonctionnement où l'écran n'émet pas de lumière indiqué par ce signal corresponde à l'instant réel de début de la phase de fonctionnement suivante où l'écran n'émet pas de lumière. La détermination du retard introduit par le circuit de retard peut par exemple être mise en oeuvre lors d'une phase d'étalonnage du système 1000, et en particulier du circuit de retard.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, on peut prévoir que la synchronisation entre les phases de mesure du capteur 104 et les phases de fonctionnement de l'écran où il n'émet pas de lumière soit réalisée en combinant le mode de réalisation de la figure 4 ou 5 avec le mode de réalisation de la figure 6 ou 7. L'étendue de la protection est cependant définie par le contenu des revendications.

Enfin, la mise en oeuvre pratique des modes de réalisation et variantes décrits est à la portée de l'homme du métier à partir des indications fonctionnelles données ci-dessus.

## Revendications

1. Système électronique (1000) comprenant :
un circuit de commande (108) configuré pour fournir un signal binaire de commande (sig-c) alternant entre un premier état binaire lors de premières phases et un deuxième état binaire lors de deuxièmes phases ;
un écran (100) commandé par le signal de commande (sig-c), l'écran étant configuré pour émettre de la lumière pendant chaque première phase, et pour n'émettre aucune lumière pendant chaque deuxième phase ;
un capteur de lumière (104) disposé sous l'écran ou le long d'un bord de l'écran, et configuré pour fournir un signal de mesure (sig-m) représentatif d'une quantité de lumière reçue par le capteur pendant une phase de mesure ou plusieurs phases de mesures consécutives ; et
un dispositif de synchronisation (104, 600) configuré pour synchroniser chaque phase de mesure avec une deuxième phase, le dispositif de synchronisation comprenant :
le capteur (104), le capteur étant en outre configuré pour générer un signal (sig-e) représentatif de l'évolution, en fonction du temps, de la lumière reçue par le capteur (104) ; et
un circuit de traitement (600) configuré pour déterminer, à partir du signal (sig-e) représentatif de l'évolution de la lumière reçue par le capteur (104), le début de chaque deuxième phase.

2. Système selon la revendication 1, dans lequel le dispositif de synchronisation est configuré pour synchroniser le début de chaque phase de mesure avec le début d'une deuxième phase.

3. Système selon la revendication 1 ou 2, comprenant une unité de traitement (106), le circuit de commande étant configuré pour déterminer le signal binaire de commande (sig-c) à partir d'un signal de consigne (sig-t) fourni par l'unité de traitement.

4. Système selon la revendication 3, dans lequel l'unité de traitement (106) est en outre configurée pour activer et désactiver le circuit de commande (108).

5. Système selon la revendication 3 ou 4, dans lequel l'unité de traitement (106) est configurée pour déterminer le signal de consigne (sig-t) à partir du signal de mesure (sig-m) et d'une consigne d'un utilisateur du système.

6. Système selon l'une quelconque des revendications 3 à 5, dans lequel le circuit de traitement (600) fait partie de l'unité de traitement (106).

7. Système selon l'une quelconque des revendications 1 à 5, dans lequel le circuit de traitement (600) fait partie du capteur (104).

8. Système selon l'une quelconque des revendications 1 à 7, dans lequel le circuit de traitement (600) est en outre configuré pour déterminer un signal de synchronisation (sig-s3) du début d'une phase de mesure, à partir de la détermination du début de chaque deuxième phase.

9. Système selon l'une quelconque des revendications 1 à 8, dans lequel le circuit de traitement est en outre configuré pour déterminer une fréquence des premières et deuxièmes phases et/ou un rapport cyclique entre les premières et deuxièmes phases.

10. Système selon l'une quelconque des revendications 1 à 9, dans lequel la durée de chaque phase de mesure est inférieure à la durée de la deuxième phase avec laquelle est synchronisée la phase de mesure.

11. Dispositif électronique tel qu'un téléphone mobile (2000, 3000), une tablette ou un appareil multimédia comprenant un système (1000) selon l'une quelconque des revendications 1 à 10.

12. Procédé mis en oeuvre dans un système (1000) selon l'une quelconque des revendications 1 à 10 ou dans un dispositif électronique (2000, 3000) selon la revendication 11, dans lequel chaque phase de mesure est mise en oeuvre pendant une deuxième phase.

## Patentansprüche

1. Ein elektronisches System (1000), das Folgendes aufweist:
eine Steuerschaltung (108), die konfiguriert ist zum Bereitstellen eines binären Steuersignals (sig-c), das zwischen einem ersten binären Zustand während erster Phasen und einem zweiten binären Zustand während zweiter Phasen wechselt;
einen Schirm (100), der durch das Steuersignal (sig-c) gesteuert wird, wobei der Schirm konfiguriert ist um während jeder ersten Phase Licht zu emittieren und während jeder zweiten Phase kein Licht zu emittieren;
einen Lichtsensor (104), der unter dem Schirm oder entlang einer Kante des Schirms angeordnet ist und der konfiguriert ist zum Vorsehen eines Messsignals (sig-m), das eine Lichtmenge repräsentiert, die von dem Sensor während einer Messphase oder einer Vielzahl von aufeinanderfolgenden Messphasen empfangen wird; und
eine Synchronisationsvorrichtung (104, 600), die konfiguriert ist zum Synchronisieren jede Messphase mit einer zweiten Phase,
wobei die Synchronisationsvorrichtung folgendes aufweist:
den Sensor (104), wobei der Sensor ferner konfiguriert ist zum Erzeugen eines Signals (sig-e), das die Entwicklung des von dem Sensor (104) empfangenen Lichts als eine Funktion der Zeit repräsentiert; und
eine Verarbeitungsschaltung (600), die konfiguriert ist zum Bestimmen, basierend auf dem Signal (sig-e), das die Entwicklung des von dem Sensor (104) empfangenen Lichts repräsentiert, des Beginns jeder zweiten Phase.

2. System nach Anspruch 1, wobei die Synchronisationsvorrichtung konfiguriert ist zum Synchronisieren des Beginns jeder Messphase mit dem Beginn einer zweiten Phase.

3. System nach Anspruch 1 oder 2, das eine Verarbeitungseinheit (106) aufweist, wobei die Steuerschaltung konfiguriert ist zum Bestimmen des binären Steuersignals (sig-c) basierend auf einem von der Verarbeitungseinheit bereitgestellten Sollwertsignal (sig-t).

4. System nach Anspruch 3, wobei die Verarbeitungseinheit (106) ferner konfiguriert ist zum Aktivieren und Deaktivieren der Steuerschaltung (108).

5. System nach Anspruch 3 oder 4, wobei die Verarbeitungseinheit (106) konfiguriert ist zum Bestimmen des Sollwertsignals (sig-t) basierend auf dem Messsignal (sig-m) und einem Sollwert von einem Benutzer des Systems.

6. System nach einem der Ansprüche 3 bis 5, wobei die Verarbeitungsschaltung (600) Teil der Verarbeitungseinheit (106) ist.

7. System nach einem der Ansprüche 1 bis 5, wobei die Verarbeitungsschaltung (600) Teil des Sensors (104) ist.

8. System nach einem der Ansprüche 1 bis 7, wobei die Verarbeitungsschaltung (600) ferner konfiguriert ist zum Bestimmen eines Synchronisationssignals (sig-s3) zum Synchronisieren des Beginns einer Messphase, basierend auf der Bestimmung des Beginns jeder zweiten Phase.

9. System nach einem der Ansprüche 1 bis 8, wobei die Verarbeitungsschaltung ferner konfiguriert ist zum Bestimmen einer Frequenz der ersten und zweiten Phasen und/oder eines Tastverhältnis zwischen den ersten und zweiten Phasen.

10. System nach einem der Ansprüche 1 bis 9, wobei die Dauer jeder Messphase kleiner ist als die Dauer der zweiten Phase, mit der die Messphase synchronisiert ist.

11. Ein elektronisches Gerät wie ein Mobiltelefon (2000, 3000), ein Tablet oder ein Multimediagerät, das ein System (1000) nach einem der Ansprüche 1 bis 10 aufweist.

12. Verfahren, das in einem System (1000) nach einem der Ansprüche 1 bis 10 oder in einem elektronischen Gerät (2000, 3000) nach Anspruch 11 implementiert ist, wobei jede Messphase während einer zweiten Phase implementiert wird.

## Claims

1. An electronic system (1000) comprising:
a control circuit (108) configured to provide a binary control signal (sig-c) alternating between a first binary state during first phases and a second binary state during second phases;
a screen (100) controlled by the control signal (sig-c), the screen being configured to emit light during each first phase, and to not emit any light during each second phase;
a light sensor (104) disposed under the screen or along an edge of the screen, and configured to provide a measurement signal (sig-m) representative of a quantity of light received by the sensor during a measurement phase or a plurality of consecutive measurement phases; and
a synchronisation device (104, 600) configured to synchronise each measurement phase with a second phase,
the synchronisation device comprising:
the sensor (104), the sensor being further configured to generate a signal (sig-e) representative of the evolution, as a function of time, of the light received by the sensor (104); and
a processing circuit (600) configured to determine, based on the signal (sig-e) representative of the evolution of the light received by the sensor (104), the start of each second phase.

2. The system according to claim 1, wherein the synchronisation device is configured to synchronise the start of each measurement phase with the start of a second phase.

3. The system according to claim 1 or 2, comprising a processing unit (106), the control circuit being configured to determine the binary control signal (sig-c) based on a setpoint signal (sig-t) provided by the processing unit.

4. The system according to claim 3, wherein the processing unit (106) is further configured to activate and deactivate the control circuit (108).

5. The system according to claim 3 or 4, wherein the processing unit (106) is configured to determine the setpoint signal (sig-t) based on the measurement signal (sig-m) and a setpoint from a user of the system.

6. The system according to any of claims 3 to 5, wherein the processing circuit (600) is part of the processing unit (106) .

7. The system according to any of claims 1 to 5, wherein the processing circuit (600) is part of the sensor (104).

8. The system according to any of claims 1 to 7, wherein the processing circuit (600) is further configured to determine a synchronisation signal (sig-s3) for synchronising the start of a measurement phase, based on the determination of the start of each second phase.

9. The system according to any of claims 1 to 8, wherein the processing circuit is further configured to determine a frequency of the first and second phases and/or a duty cycle between the first and second phases.

10. The system according to any of claims 1 to 9, wherein the duration of each measurement phase is less than the duration of the second phase with which the measurement phase is synchronised.

11. An electronic device such as a mobile telephone (2000, 3000), a tablet or a multimedia apparatus comprising a system (1000) according to any of claims 1 to 10.

12. A method implemented in a system (1000) according to any of claims 1 to 10 or in an electronic device (2000, 3000) according to claim 11, wherein each measurement phase is implemented during a second phase.
